(19) Europäisches Patentamt
European Patent Office
Office européen des brevets

(11) **EP 2 485 396 B1**

(12) **FASCICULE DE BREVET EUROPEEN**

(45) Date de publication et mention
de la délivrance du brevet:
**11.12.2019 Bulletin 2019/50**

(51) Int Cl.:
***H03H 7/40*** (2006.01)

(21) Numéro de dépôt: **12153564.5**

(22) Date de dépôt: **02.02.2012**

(54) **Procédé de connexion sur une seule antenne d'un ou de plusieurs composants sans contact, et système correspondant**

Verfahren zum Anschluss einer oder mehreren kontaktlosen Komponenten auf einer einzigen Antenne, und entsprechendes System

Method for connecting two or more contactless elements on a single antenna and corresponding sytem

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.02.2011 FR 1150931**

(43) Date de publication de la demande:
**08.08.2012 Bulletin 2012/32**

(73) Titulaire: **STMicroelectronics (Rousset) SAS 13790 Rousset (FR)**

(72) Inventeurs:
• **Tramoni, Alexandre**
  **83330 Le Beausset (FR)**
• **Rizzo, Pierre**
  **13530 TRETS (FR)**

(74) Mandataire: **Zapalowicz, Francis**
  **Casalonga & Partners**
  **Bayerstrasse 71/73**
  **80335 München (DE)**

(56) Documents cités:
**EP-A1- 2 107 694**      **US-A1- 2007 063 041**
**US-A1- 2009 101 716**   **US-A1- 2009 212 917**

EP 2 485 396 B1

**Description**

L'invention concerne les composants électroniques connectés à une antenne, et plus particulièrement la connexion sur une seule antenne d'un ou de plusieurs composants, en particulier des composants configurés pour échanger des informations avec un dispositif externe via ladite antenne selon un protocole de communication du type sans contact. De tels composants sont plus simplement appelés par abus de langage « composants sans contact » et peuvent être par exemple des composants dits « NFC », c'est-à-dire des composants compatibles avec la technologie NFC (« Near Field Communication »).

Outre sa fonction téléphonique classique, un téléphone mobile cellulaire peut être utilisé pour échanger des informations avec un dispositif externe sans contact en utilisant un protocole de communication sans contact, par exemple le protocole type A défini dans la norme ISO/IEC 14 443.

Ceci permet d'échanger des informations entre le dispositif externe sans contact, par exemple un lecteur, et un composant sans contact situé dans le téléphone. De nombreuses applications sont ainsi possibles, telles que le franchissement de barrière de péage dans les transports (le téléphone mobile agit comme ticket de transport) ou bien des applications de paiement (le téléphone mobile agit comme une carte de crédit).

L'acronyme NFC (« Near Field Communication ») désigne une technologie de communication sans fil haute fréquence faible distance, qui permet des échanges de données entre deux dispositifs sans contact sur une faible distance, par exemple 10 cm.

La technologie NFC est normalisée dans les documents ISO/IEC 18 092 et ISO/IEC 21 481 mais incorpore une variété de normes préexistantes incluant les protocoles type A et type B de la norme ISO/IEC 14 443.

Le document EP 2 107 694 A1 décrit un terminal d'émission/réception radio fréquence par couplage inductif possédant un interrupteur permettant au terminal de fonctionner soit en mode lecteur (position ouverte de l'interrupteur) soit en mode carte (position fermée de l'interrupteur).

Le document US 2007/0063041 A1 décrit une carte à circuit intégré dans laquelle le processeur peut fonctionner dans un mode carte ou dans un mode de lecture/écriture en fonction de la position fermée ou ouverte d'un interrupteur.

Le document US 2009/0212917 A1 décrit un procédé de communication sans contact dans lequel une unité d'antenne est utilisée par deux circuits de communication sans contact pour des communications RFID dans respectivement un premier mode et un deuxième mode.

Le document US 2009/0101716 A1 décrit un lecteur à couplage inductif ayant un circuit d'interface passif pour extraire un signal de données d'un circuit d'antenne ainsi qu'un circuit pour coupler le lecteur à un module de sécurité amovible.

Compte tenu de la croissance du marché des applications sans contact, il devient particulièrement intéressant, lorsqu'on dispose d'un appareil de communication sans fil, par exemple un téléphone mobile cellulaire, déjà équipé d'un composant sans contact capable de dialoguer avec un dispositif sans contact externe, par exemple un lecteur, via une antenne, de pouvoir connecter sur cette même antenne, un autre composant sans contact.

Ceci permet en particulier de pouvoir clairement séparer les applications provenant de différentes sources (banques, opérateurs de transport, opérateurs téléphoniques, ...). Dans la description suivante, il est proposé un procédé et un système permettant, au choix, de connecter ou non un deuxième composant sans contact sur l'antenne déjà connectée à un premier composant sans contact, par exemple incorporé dans un téléphone mobile cellulaire, et ce de façon à permettre un fonctionnement individuel sélectif de chaque composant, et en particulier du premier composant en présence ou non du deuxième composant connecté, avec le moins de perturbation possible.

Selon un exemple, il est proposé un procédé de connexion sur une seule antenne d'un ou de plusieurs composants configurés pour échanger des informations avec un dispositif externe via ladite antenne selon un protocole de communication du type sans contact utilisant une fréquence de porteuse, par exemple la fréquence 13,56 MHz du protocole type A ou B défini dans la norme ISO/IEC 14 443, le procédé comprenant

- une connexion d'un premier composant à l'antenne et à un circuit d'adaptation d'impédance configurable sur commande et connecté à l'antenne, et
- en l'absence d'un autre composant connecté à l'antenne, un placement du circuit d'adaptation d'impédance dans une première configuration dans laquelle il forme avec le premier composant et l'antenne un circuit résonant ayant une première fréquence de résonance compatible avec ladite fréquence de porteuse, et
- en présence d'un deuxième composant connecté à l'antenne, un placement du circuit d'adaptation d'impédance dans une deuxième configuration dans laquelle il forme avec le premier composant, le deuxième composant et l'antenne un circuit résonant ayant une deuxième fréquence de résonance (qui peut être égale ou différente de la première fréquence de résonance) compatible avec ladite fréquence de porteuse.

Ainsi, selon cet exemple, on agit directement au niveau du circuit d'adaptation d'impédance pour le configurer différemment selon qu'un seul composant est connecté à l'antenne, ou que le deuxième composant est également connecté à l'antenne. Et, de ce fait, le circuit d'adaptation d'impédance dans sa première configuration, permet de former avec l'antenne un circuit résonant à une fréquence de résonance appropriée, par exemple 13,56 Mhz ou voisine de 13,56 MHz pour la norme ISO/IEC 14 443, ce qui permet au premier composant de dialoguer avec le dispositif sans contact externe en utilisant la fréquence de porteuse. Lorsque le deuxième composant est connecté, le placement du circuit d'adaptation d'impédance dans sa deuxième configuration permet, moyennant une valeur adéquate pour la valeur capacitive que présente le deuxième composant, de pouvoir également former avec l'antenne et les premiers et deuxième composants, un circuit résonant à une fréquence de résonance appropriée, par exemple 13,56 Mhz ou bien une fréquence très proche. Ainsi, même avec le premier composant connecté, le deuxième composant peut dialoguer avec un dispositif sans contact externe en utilisant la fréquence de porteuse, et même avec le deuxième composant connecté, le premier composant peut dialoguer avec un dispositif sans contact externe en utilisant la fréquence de porteuse. Bien entendu, de façon à éviter des conflits, il est particulièrement avantageux de prévoir par exemple une adaptation logicielle de protocole, interdisant lorsque les deux composants sont connectés, que ceux-ci puissent communiquer simultanément.

Une fréquence de résonance compatible avec la fréquence de porteuse est une fréquence permettant un dialogue du composant avec un dispositif externe en utilisant la porteuse du protocole de communication sans contact ayant ladite fréquence de porteuse. Idéalement les impédances capacitives du circuit d'adaptation d'impédance, celles des composants et l'impédance inductive de l'antenne sont choisies pour obtenir des fréquences de résonance égales ou très proches de la fréquence de porteuse. Dans ce cas où les fréquences de résonance sont égales à la fréquence de porteuse le fonctionnement est optimisé avec par exemple une distance de fonctionnement maximale. Cela étant l'homme du métier sait qu'une fréquence de résonance différente de la fréquence de porteuse permet néanmoins un fonctionnement selon le protocole de communication sans contact avec toutefois des performances dégradées, par exemple en terme de distance ou de débit. Les fréquences de résonance compatibles peuvent donc être choisies dans des plages de fréquences contenant ladite fréquence de porteuse. L'homme du métier saura ajuster la taille de ces plages de fréquences compte tenu de ou des applications envisagées et/ou des performances désirées, par exemple en terme de portée et/ou de débit de données transmises.

Ainsi, à titre indicatif dans le cas d'un protocole de transmission type A défini dans la norme ISO/IEC 14443 utilisant une modulation d'une porteuse ayant une fréquence de porteuse égale à 13,56 MHz, des fréquences de résonance contenues dans une plage de plus ou moins 15% autour de la fréquence de porteuse, peuvent être considérées comme des fréquences compatibles.

Selon un aspect, il est proposé un système électronique comme défini dans la revendication 1.

Le fait d'agir au niveau du circuit d'adaptation d'impédance à l'arrière des deuxième et troisième condensateurs permet l'utilisation de dispositifs de commutation classique, par exemple des transistors. En effet, les valeurs de tension lors de ces commutations sont faibles par rapport à celles qui seraient apparues dans le cas où une commutation directe au niveau du premier condensateur aurait été envisagée, car c'est aux bornes de ce premier condensateur que le circuit résonne.

Selon un mode de réalisation, les moyens commandables d'activation/désactivation comprennent au moins un transistor PMOS connecté en série entre les deuxième et troisième condensateurs et commandable sur sa grille.

Selon un autre aspect, il est proposé un appareil de communication sans fil, par exemple un téléphone mobile cellulaire, comprenant un système électronique tel que défini ci avant.

D'autres avantages et caractéristiques de l'invention apparaîtront à l'examen de la description détaillée de modes de mise en œuvre et de réalisation et des dessins annexés sur lesquels :

- la figure 1 illustre schématiquement un mode de réalisation d'un système selon l'invention,
- les figures 2 et 3 illustrent schématiquement des modes de mise en œuvre du procédé selon l'invention,
- la figure 4 illustre schématiquement un autre mode de réalisation d'un système selon l'invention, et
- la figure 5 illustre schématiquement un mode de réalisation d'un appareil de communication sans fil selon l'invention.

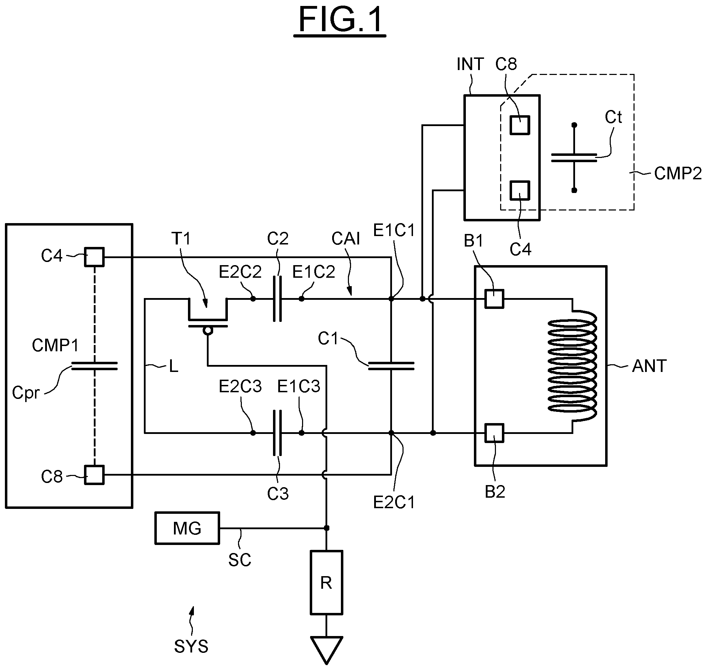

Sur la figure 1, la référence SYS désigne un système électronique comprenant un premier composant CMP1.

Ce composant CMP1 peut être par exemple un élément sécurisé (secure element), ou UICC. UICC tel que défini dans le document ETSI TR 102 216 V3.0.0 (09 2003), qui n'est ni une abréviation ni un acronyme, désigne une carte à puce conforme aux spécifications écrites et maintenues par le comité technique ETSI SCP (Smart Card Plateform).

Le système SYS comporte également une antenne ANT, par exemple une antenne inductive présentant une inductance La, dont les deux bornes B1 et B2 sont connectées au composant CMP1, typiquement aux contacts C4 et C8 de ce composant lorsqu'il s'agit d'un UICC.

Le composant CMP1 présente à ses bornes une capacité, par exemple une capacité parasite, Cpr.

Le système SYS comporte également un circuit d'adaptation d'impédance CAI connecté également aux bornes B1 et B2 de l'antenne, et sur lequel est également connecté le composant CMP1.

Ce circuit d'adaptation d'impédance comporte ici un premier condensateur C1 connecté en parallèle aux bornes de l'antenne ANT. Plus précisément, le condensateur C1 a une première électrode E1C1 connectée à la borne B1 et une deuxième électrode E2C1 connectée à la borne B2 de l'antenne ANT.

Le circuit d'adaptation d'impédance CAI comporte également un chemin capacitif formé ici d'un deuxième condensateur C2 et d'un troisième condensateur C3. Le deuxième condensateur C2 possède une première électrode E1C2 connectée à la première électrode E1C1 du premier condensateur C1.

De même, le troisième condensateur C3 possède une première électrode E1C3 connectée à la deuxième électrode E2C1 du premier condensateur C1.

La deuxième électrode E2C2 du deuxième condensateur C2 et la deuxième électrode E2C3 du troisième condensateur C3 sont mutuellement connectées par l'intermédiaire d'un transistor PMOS T1 formant des moyens commandables d'activation/désactivation du chemin capacitif formé par les condensateurs C2 et C3.

A cet égard, le système SYS comporte en outre des moyens de commande MC configurés pour délivrer un signal de commande SC sur la grille du transistor T1.

Une résistance R est également connectée entre la grille du transistor T1 et la masse.

Comme on le verra plus en détail ci après, le transistor T1 possède un premier état dans lequel il est passant et permet par conséquent de réaliser un court-circuit L entre les deuxième et troisième condensateurs C2 et C3.

Le transistor T1 possède également un deuxième état dans lequel il est bloqué, supprimant par conséquent une connexion effective mutuelle des deuxième et troisième condensateurs C2 et C3.

Lorsque le signal de commande SC délivré par les moyens de génération MG est un signal haute impédance, la résistance R reliée à la masse tire la tension de grille du transistor T1 à la masse (0 volt), ce qui permet de rendre passant ce transistor T1.

Par contre, lorsque les moyens de génération MG délivrent un signal de commande SC ayant un état logique haut, par exemple 3 volts, le transistor T1 est bloqué.

Outre les éléments qui viennent d'être décrits, le système SYS comporte également une interface INT connectée en parallèle aux deux bornes B1 et B2 de l'antenne ANT et capable de recevoir de façon amovible un deuxième composant CMP2.

Ce composant CMP2 peut être par exemple un autre élément sécurisé (secure element), ou UICC. Dans ce cas les contacts C4 et C8 du composant CMP2 (UICC) sont connectés via l'interface INT aux bornes B2 et B1 de l'antenne.

Le deuxième composant CMP2 pourrait être également par exemple une clé USB radiofréquence adaptée à un fonctionnement selon un protocole de communication sans contact, l'interface INT étant alors un port USB, ou bien une carte SD (Secure Digital) ou µSD adaptée à un fonctionnement selon un protocole sans contact et aisément connectable à un téléphone cellulaire.

Le composant CMP2 présente entre ces deux contacts, couplée à l'antenne ANT via l'interface INT, une capacité ayant une valeur Ct.

De façon à avoir un fonctionnement optimisé, un composant sans contact forme avec l'antenne et le circuit d'adaptation d'impédance un circuit résonant ayant une fréquence de résonance f égale à la fréquence de porteuse exemple 13,56 Mhz.

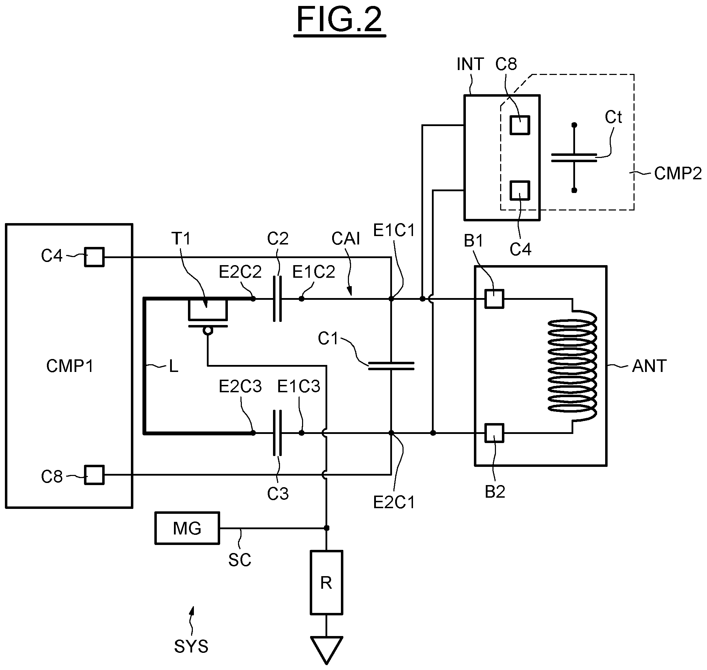

Aussi, lorsque, comme illustré sur la figure 2, aucun deuxième composant CMP2 n'est connecté à l'antenne ANT par l'intermédiaire de l'interface INT, le transistor T1 est dans son état passant court-circuitant les deux condensateurs C2 et C3 et, si Cs désigne la valeur capacitive de chacun des condensateurs C2 et C3 et Cp désigne la valeur capacitive du premier condensateur C1, ces valeurs capacitives sont choisies de façon à satisfaire à la formule (1) ci-dessous :

$$f1 = 13,56 Mhz = \cfrac{1}{2\pi \sqrt{La\left(\cfrac{Cs}{2} + Cpr + Cp\right)}} \qquad (1)$$

dans laquelle La désigne la valeur inductive de l'antenne ANT et f1 la fréquence de résonance du circuit résonant.

Si l'on venait connecter le composant CMP2 sur le système SYS configuré comme illustré sur la figure 2, alors, l'ensemble du circuit résonnerait à une fréquence ft bien différente de 13,56 Mhz. En effet, la fréquence de résonance ft serait définie par la formule (2) ci-dessous :

$$ft = \cfrac{1}{2\pi \sqrt{La\left(\cfrac{Cs}{2} + (Cp + Cpr + Ct)\right)}} \qquad (2)$$

Et, on voit que puisque les capacités Cs et Cp ont été calculées pour permettre d'obtenir une fréquence de résonance de 13,56 Mhz, la fréquence de résonance ft serait alors bien différente de la fréquence 13,56 Mhz, quelle que soit la valeur de la capacité Ct.

Il en résulterait donc un risque important de mauvais fonctionnement non seulement du composant CMP1 mais également du composant CMP2.

Le fait que le chemin capacitif formé des condensateurs C2 et C3 puisse être activé ou désactivé, permet de résoudre ce problème.

En effet, comme illustré sur la figure 2, lorsque aucun composant CMP2 n'est logé dans l'interface INT, le circuit d'adaptation d'impédance est effectivement formé des condensateurs C1, C2 et C3 (le transistor T1 est passant), ce qui permet d'obtenir une fréquence de résonance f1 définie par la formule (1), et égale à 13,56 Mhz par exemple, autorisant alors un fonctionnement optimisé pour le composant CMP1.

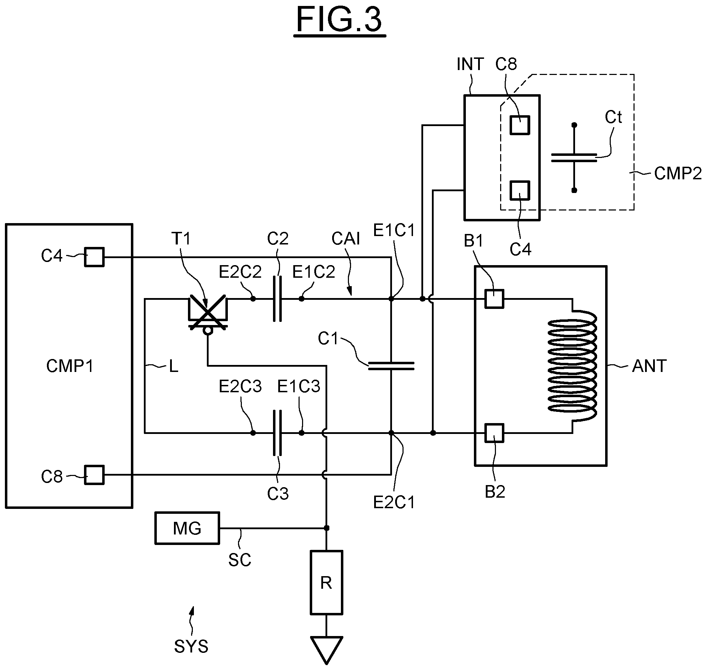

Par contre, lorsque le composant CMP2 est logé dans l'interface INT (figure 3), les moyens de commande MG rendent le transistor T1 bloqué, et la nouvelle fréquence de résonance f2 du circuit formé par le premier composant CMP1, le deuxième composant CMP2, le circuit d'adaptation d'impédance dans sa deuxième configuration et l'antenne, est alors définie par la formule (3) ci-dessous :

$$f2 = \frac{1}{2\pi\sqrt{La(Ct + Cpr + Cp)}} \qquad (3)$$

Moyennant un choix convenable pour la valeur capacitive Ct du composant CMP2 (prise égale par exemple à Cs/2), il devient alors possible d'ajuster cette fréquence de résonance f2 à la valeur de 13,56 Mhz, ce qui permet de pouvoir choisir le composant qui dialoguera avec un dispositif externe tout en offrant un fonctionnement optimisé pour le composant sélectionné.

Et le fait d'avoir supprimé les condensateurs C2 et C3 dans cette configuration et donc supprimé une valeur capacitive, donne beaucoup plus de souplesse pour pouvoir rajouter une autre capacité (capacité Ct) et atteindre une fréquence de résonance f2 acceptable voire optimale.

Ainsi, le fait de rendre différent le circuit d'adaptation d'impédance en fonction de la connexion ou non du deuxième composant CMP2 à l'antenne, permet de garantir un fonctionnement correct de chacun des composants CMP1 et CMP2 quelle que soit la configuration adoptée.

Il devient donc possible d'utiliser deux composants sans contact avec la même antenne ANT tout en offrant la possibilité d'avoir un fonctionnement optimisé pour le composant CMP1 que le composant CMP2 soit connecté ou non, et pour le composant CMP2 lorsqu'il est connecté.

Par ailleurs, le courant de commutation (ou la tension de commutation) mis en œuvre au niveau du transistor T1 est de faible valeur, car la commutation s'effectue entre les électrodes E2C2 et E2C3 des deux condensateurs C2 et C3, et non aux bornes du premier condensateur C1, ce qui permet d'utiliser des transistors PMOS classiques et non des composants haute tension.

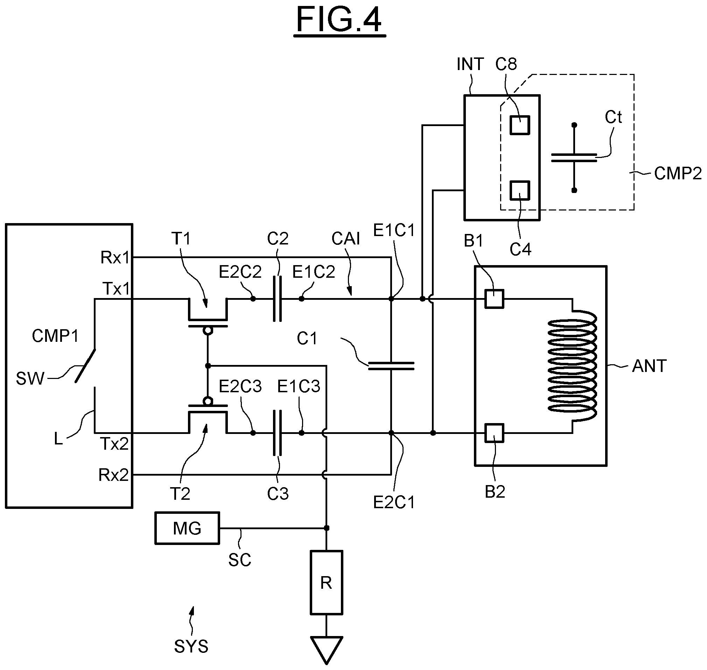

En variante, comme illustré sur la figure 4, le composant CMP1 peut être un composant NFC tel qu'un micro-contrôleur NFC, par exemple le composant commercialisé par la société STMicroelectronics sous la référence ST21NFC A.

Ce composant présente la particularité de pouvoir être utilisé en mode « carte » ou bien en mode « lecteur ». A cet égard, un commutateur interne SW permet de court-circuiter les bornes TX1 et TX2 pour autoriser un fonctionnement en mode carte, ou de ne pas court-circuiter ces bornes TX1 et TX2 pour autoriser un fonctionnement en mode lecteur.

Le composant comporte également deux autres bornes RX1 et RX2 connectées aux bornes du premier condensateur C1.

Pour la mise en œuvre de la présente invention, le composant CMP1 est utilisé en mode carte.

Dans ce cas, les moyens d'activation/désactivation comprennent deux transistors PMOS T1 et T2, commandés sur leur grille respective par le signal SC, et respectivement connectés entre les condensateurs C2, C3 et les bornes TX1, TX2.

Ce qui vient d'être décrit pour le transistor T1 des figures 1 à 3, s'appliquent ici aux deux transistors T1 et T2.

La liaison L entre les deux transistors T1 et T2, qui permet d'assurer le court-circuit entre les condensateurs C2 et C3 lorsque les transistors T1 et T2 sont passants, est donc réalisée ici à l'intérieur du composant CMP1.

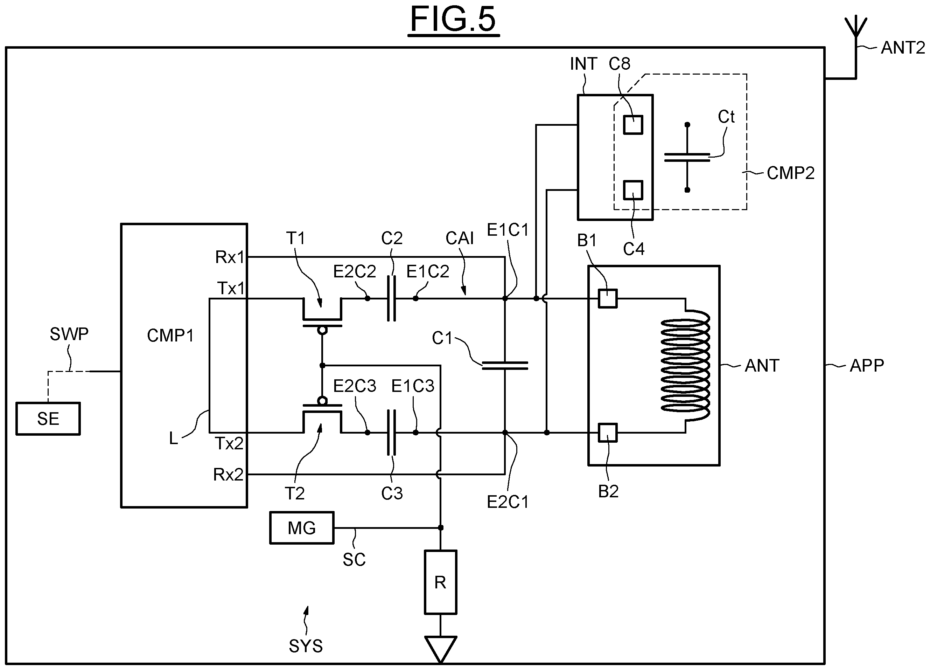

Comme illustré sur la figure 5, le système SYS peut être logé dans un appareil de communication sans fil APP, par exemple un téléphone mobile cellulaire capable d'assurer sa fonction de téléphonie avec une station de base par exemple, via une antenne ANT2.

Le téléphone peut également permettre un échange de données via un protocole de communication sans contact avec un dispositif externe, par exemple un lecteur, via l'antenne ANT en utilisant le composant CMP1 ou CMP2.

Lorsque le composant CMP1 est un micro-contrôleur NFC, par exemple le composant ST21NFCA Le téléphone APP peut également contenir un élément sécurisé SE (UICC) connecté au composant CMP1 par un bus de liaison SWP, c'est-à-dire un bus supportant le protocole SWP défini dans la norme ETSI TS 102 613.

**Revendications**

1. Système électronique, comprenant
une antenne (ANT) configurée pour une communication sans contact, l'antenne ayant une première borne (B1) et une deuxième borne (B2),
un premier composant (CMP1) configuré pour communiquer via l'antenne selon un protocole de communication du type sans contact utilisant une fréquence de porteuse,
un circuit d'adaptation d'impédance (CAI) configurable sur commande et connecté au premier composant ainsi qu'aux bornes de l'antenne,
une interface (INT) connectée aux bornes de l'antenne et au circuit d'adaptation d'impédance et configurée pour être connectée de façon amovible avec un deuxième composant (CMP2) configuré pour communiquer selon un protocole de communication du type sans contact utilisant ladite fréquence de porteuse,
le circuit d'adaptation d'impédance (CAI) possédant un premier condensateur (C1) connecté en parallèle sur l'antenne ainsi qu'un chemin capacitif (C2, C3) activable/désactivable connecté en parallèle sur l'antenne, le chemin capacitif comprenant un deuxième condensateur (C2) possédant une première électrode connectée à une première borne de l'antenne, un troisième condensateur (C3) possédant une première électrode connectée à une deuxième borne de l'antenne et des moyens commandables (T1) d'activation/désactivation connectés en série entre une deuxième électrode du deuxième condensateur et une deuxième électrode du troisième condensateur, les moyens commandables (T1) d'activation/désactivation possédant un premier état correspondant à l'état activé du chemin capacitif dans lequel ils autorisent une connexion effective mutuelle des deuxièmes électrodes des deuxième et troisième condensateurs, et un deuxième état correspondant à l'état désactivé du chemin capacitif dans lequel ils suppriment la connexion effective mutuelle des deuxièmes électrodes des deuxième et troisième condensateurs, et des moyens de commande (MG, R) configurés pour commander les moyens d'activation/désactivation de façon à placer le circuit d'adaptation d'impédance, en l'absence de deuxième composant connecté avec ladite interface, dans une première configuration dans laquelle il forme avec le premier composant et l'antenne un circuit résonant ayant une première fréquence de résonance compatible avec ladite fréquence de porteuse et en présence du deuxième composant connecté avec ladite interface, dans une deuxième configuration dans laquelle il forme avec le premier composant, le deuxième composant et l'antenne un circuit résonant ayant une deuxième fréquence de résonance compatible avec ladite fréquence de porteuse, ledit chemin capacitif étant dans son état activé dans ladite première configuration du circuit d'adaptation d'impédance et dans son état désactivé dans ladite deuxième configuration du circuit d'adaptation d'impédance.

2. Système selon la revendication 1, dans lequel les moyens commandables d'activation/désactivation comprennent au moins un transistor PMOS (T1) connecté en série entre les deuxième et troisième condensateurs et commandable sur sa grille.

3. Système selon l'une des revendications précédentes, dans lequel ledit premier composant (CMP1) est un composant compatible avec la technologie de communication champ proche dite NFC.

4. Appareil de communication sans fil, comprenant un système selon l'une des revendications 1 à 3.

**Patentansprüche**

1. Elektronisches System, das Folgendes umfasst:

eine Antenne (ANT), konfiguriert für kontactlose kommunikation, wobei die Antenne einen ersten Anschluss (B1) und einen zweiten Anschluss (B2) hat,
eine erste Komponente (CMP1), konfiguriert zum Kommunizieren über die Antenne gemäß einem Kommunikationsprotokoll vom kontactlosen typ unter Verwendung einer Trägerfrequenz,
eine Impedanzanpassungsschaltung (CAI), die auf Befehl konfigurierbar ist und mit der ersten Komponente sowie den Anschlüssen der Antenne verbunden ist,
eine Schnittstelle (INT), die mit den Anschlüssen der Antenne und mit der Impedanzanpassungsschaltung verbunden ist und konfiguriert ist, um entfernbar mit einer zweiten Komponente (CMP2) verbunden werden zu können, die konfiguriert ist zum Kommunizieren gemäß einem Kommunikationsprotokoll vom kontactlosen typ unter Verwendung der Trägerfrequenz,

wobei die Impedanzanpassungsschaltung (CAI) einen ersten Kondensator (C1) besitzt, der parallel an die Antenne angeschlossen ist, und einen aktivierbaren/deaktivierbaren kapazitiven Pfad (C2, C3), der parallel an die Antenne angeschlossen ist, wobei der kapazitive Pfad einen zweiten Kondensator (C2) umfasst, der eine erste Elektrode besitzt, die mit einem ersten Anschluss der Antenne verbunden ist, und einen dritten Kondensator (C3), der eine erste Elektrode besitzt, die mit einem zweiten Anschluss der Antenne und steuerbaren Mitteln (T1) zur Aktivierung/Deaktivierung verbunden ist, die in Reihe zwischen einer zweiten Elektrode des zweiten Kondensators und einer zweiten Elektrode des dritten Kondensators angeschlossen sind, wobei die steuerbaren Mittel (T1) zur Aktivierung/Deaktivierung einen ersten Zustand besitzen, der einem aktivierten Zustand des kapazitiven Pfades entspricht, in dem sie eine effektive gemeinsame Verbindung der zweiten Elektroden des zweiten und des dritten Kondensators zulassen, und einen zweiten Zustand, der einem deaktivierten Zustand des kapazitiven Pfades entspricht, in dem sie eine effektive gemeinsame Verbindung der zweiten Elektroden des zweiten und des dritten Kondensators unterbinden, und

Mittel zur Steuerung (MG, R), konfiguriert zum Steuern der Mittel zur Aktivierung/Deaktivierung in der Art, dass die Impedanzanpassungsschaltung beim Fehlen der zweiten Komponente, die an die Schnittstelle angeschlossen ist, in einer ersten Konfiguration platziert wird, in der sie zusammen mit der ersten Komponente und der Antenne einen Resonanzkreis bildet, der eine erste Resonanzfrequenz hat, die mit der Trägerfrequenz kompatibel ist, und beim Vorhandensein der zweiten Komponente, die an die Schnittstelle angeschlossen ist, in einer zweiten Konfiguration platziert wird, in der sie zusammen mit der ersten Komponente, der zweiten Komponente und der Antenne einen Resonanzkreis bildet, der eine zweite Resonanzfrequenz hat, die mit der Trägerfrequenz kompatibel ist, wobei sich der kapazitive Pfad in der ersten Konfiguration der Impedanzanpassungsschaltung in seinem aktivierten Zustand befindet und in der zweiten Konfiguration der Impedanzanpassungsschaltung in seinem deaktivierten Zustand.

2. System nach Anspruch 1, in dem die steuerbaren Mittel zur Aktivierung/Deaktivierung mindestens einen PMOS-Transistor (T1) umfassen, der in Reihe zwischen dem zweiten und dem dritten Kondensator angeschlossen ist und über sein Gate gesteuert werden kann.

3. System nach einem der vorhergehenden Ansprüche, bei dem die erste Komponente (CMP1) eine mit der Technik der Nahfeldkommunikation, NFC, kompatible Komponente ist.

4. Vorrichtung zur drahtlosen Kommunikation, die ein System nach einem der Ansprüche 1 bis 3 umfasst.

**Claims**

1. Electronic system, comprising an antenna (ANT) that is configured for a contactless communication, the antenna having a first terminal (B1) and a second terminal (B2), a first component (CMP1) that is configured to communicate via the antenna according to a contactless type communication protocol using a carrier frequency, an impedance-matching circuit (CAI) that is configurable on command and connected to the first component and to the terminals of the antenna, an interface (INT) that is connected to the terminals of the antenna and to the impedance-matching circuit and configured to be removably connected to a second component (CMP2) that is configured to communicate according to a contactless type communication protocol using said carrier frequency,

the impedance-matching circuit (CAI) having a first capacitor (C1) that is connected in parallel with the antenna and an activatable/deactivatable capacitive path (C2, C3) that is connected in parallel with the antenna, the capacitive path comprising a second capacitor (C2) having a first electrode that is connected to a first terminal of the antenna, a third capacitor (C3) having a first electrode that is connected to a second terminal of the antenna and controllable activation/deactivation means (T1) that are connected in series between a second electrode of the second capacitor and a second electrode of the third capacitor, the controllable activation/deactivation means (T1) having a first state corresponding to an activated state of the capacitive path in which they allow the second electrodes of the second and third capacitors to be mutually effectively connected, and a second state corresponding to a deactivated state of the capacitive path in which they remove the mutual effective connection between the second electrodes of the second and third capacitors, and control means (MG, R) that are configured to control the activation/deactivation means so as to place the impedance-matching circuit, in the absence of the second component being connected to said interface, in a first configuration in which it forms, with the first component and the antenna, a resonant circuit having a first resonant frequency that is compatible with said carrier frequency and, in the presence of the second component being connected to said interface, in a second configuration in which it forms, with the first component, the second component and the antenna, a resonant circuit having a second resonant frequency that is compatible with said carrier frequency, said capacitive path being in its activated state in said first configuration of the impedance-matching circuit and in its deactivated state in said second configuration of the impedance-matching circuit.

2. System according to Claim 1, wherein the controllable activation/deactivation means comprise at least one PMOS transistor (T1) that is connected in series between the second and third capacitors and is controllable on its gate.

3. System according to either of the preceding claims, wherein said first component (CMP1) is a component that is compatible with near-field communication, known as NFC, technology.

4. Wireless communication device, comprising a system according to one of Claims 1 to 3.

FIG.1

FIG.2

FIG.3

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2107694 A1
- US 20070063041 A1
- US 20090212917 A1
- US 20090101716 A1

**Littérature non-brevet citée dans la description**

- *ETSI TR 102 216 V3.0.0,* Septembre 2003